# EUROPÄISCHE PATENTSCHRIFT

(11) **EP 3 043 942 B1**
(45) Veröffentlichungstag und Bekanntmachung des Hinweises auf die Patenterteilung: **05.07.2017**
(21) Anmeldenummer: 14777541.5
(22) Anmeldetag: 12.09.2014
(51) Int. Cl.: B23B 51/00, B23B 51/02, B23C 5/16, B23P 15/28, C23C 30/00, C23C 16/27, C23C 28/04

(54) **WERKZEUG SOWIE VERWENDUNG UND VERFAHREN ZUM ZERSPANEN VON FASERVERSTÄRKTEN MATERIALIEN**
TOOL AS WELL AS USE AND METHOD FOR MACHINING FIBER-REINFORCED MATERIALS
OUTIL AINSI QUE UTILISATION ET PROCÉDÉ D'USINAGE DE MATÉRIAUX RENFORCÉS PAR DES FIBRES

(30) Priorität: 13.09.2013 DE 102013218446
(43) Veröffentlichungstag der Anmeldung: 20.07.2016
(73) Patentinhaber: CemeCon AG, 52146 Würselen (DE)
(72) Erfinder: LEMMER, Oliver, 52066 Aachen (DE); WEIGAND, Manfred, 52066 Aachen (DE); WODA, Michael, 52080 Aachen (DE); PÜTZ, Werner, 52080 Aachen (DE); MESIC, Biljana, 52080 Aachen (DE)
(74) Vertreter: Kalkoff & Partner
(86) Internationale Anmeldenummer: PCT/EP2014/069531
(87) Internationale Veröffentlichungsnummer: WO 2015/036557

(56) Entgegenhaltungen:
- WO-A1-00/60137
- WO-A1-2007/140931
- JP-A- 2012 176 471
- US-A- 6 110 240

## Beschreibung

Die Erfindung betrifft ein Werkzeug gemäß dem Oberbegriff des Anspruchs 1, sowie eine Verwendung und ein Verfahren zum Zerspanen von faserverstärkten Materialien. Ein solches Werkzeug ist aus der WO 00/60137 A1 bekannt. Insbesondere betrifft die Erfindung die Zerspanung von faserverstärkten Verbundmaterialien, also solchen, die aus einem Verbund verschiedener Werkstoffe, darunter mindestens einem Faserwerkstoff bestehen. Dies betrifft insbesondere faserverstärkte, z. B. kohlefaserverstärkte Materialien mit einer Matrix, bspw. einer Kunststoffmatrix (CFK) oder einer Kohlenstoffmatrix (CFC).

Derartige Materialien finden insbesondere im Leichtbau Verwendung, da sie bei geringem Gewicht hohe Festigkeit aufweisen. Dementsprechend sind Anwendungen von faserverstärkten Materialien bekannt im Automobilbau, für Sportmaterialien, in der Medizintechnik, Windkraft, Raumfahrt, etc., insbesondere aber in der Luftfahrtindustrie.

Die faserverstärkten Materialien sind dabei oft Teil eines Sandwich-Materials, bestehend aus mehreren Einzellagen, darunter neben Lagen aus Faserverbundstoffen auch MetallLagen, insbesondere aus Aluminium- oder Titanlegierungen.

Die Zerspanung derartiger Materialien stellt außerordentlich hohe Anforderungen an Schneidwerkzeuge. Wegen der hohen Abrasivität der Fasern haben konventionelle Schneidwerkzeuge hier nur geringe Standzeiten. Besondere Probleme zeigen sich beim Bohren, wo es häufig zu Delamination oder zum Ausfransen des Bohrlochs kommt.

Es ist bekannt, Schneidwerkzeuge mit einer Diamantschneide zu versehen. Einerseits sind konventionelle Diamantwerkzeuge (PKD) bekannt, mit auf die Schneide gelöteten Diamanteinsätzen. Weiter können selbst Werkzeuge komplexer Werkzeuggeometrien durch das nachträgliche Aufbringen einer Diamantschicht im CVD (Chemical Vapour Deposition)-Verfahren geschützt werden.

In der WO 00/60137 sind ein Werkzeug und ein Herstellungsverfahren hierfür beschrieben. Ein Werkzeugsubstrat wird zunächst vorbehandelt und in einer CVD-Beschichtungsanlage nach dem Hot-Filament-Verfahren mit einer Diamantbeschichtung mit zwei Schichten versehen, die beide weit überwiegend Kohlenstoff in Diamantstruktur aufweisen, wobei die erste Schicht einen höheren Diamantanteil aufweist als die zweite Schicht. Der Wärmeausdehnungskoeffizient der ersten Schicht ist geringer als der des Substrats, und der Wärmeausdehnungskoeffizient der zweiten Schicht ist höher als der Wärmeausdehnungskoeffizient der ersten Schicht, so dass Risse vermieden werden.

Es ist Aufgabe der Erfindung, ein Werkzeug und ein Verfahren anzugeben, mit dem die Zerspanung von faserverstärkten Materialien besonders gut möglich ist.

Die Aufgabe wird gelöst durch ein Werkzeug gemäß Anspruch 1, eine Verwendung des Werkzeugs gemäß Anspruch 12 und ein Zerspanungsverfahren gemäß Anspruch 13.

Abhängige Ansprüche beziehen sich auf vorteilhafte Ausführungsformen der Erfindung.

Die Erfindung geht dabei aus von der Erkenntnis, dass zwar Werkzeuge mit an der Schneide, insbesondere an der Hauptfunktionsfläche aufgebrachten Diamantbeschichtung, wie sie bspw. im CVD-Verfahren erzeugt werden kann, günstige Eigenschaften bei der zerspanenden Bearbeitung vieler Materialien haben. Wie die Erfinder jedoch festgestellt haben, sind herkömmliche diamantbeschichtete Werkzeuge aber nicht ohne weiteres zum Zerspanen von faserverstärkten Materialien einsetzbar. Bei der Bearbeitung, insbesondere beim Bohren, haben die Erfinder Delamination des Sandwich-Verbundes und Faserausrisse bemerkt. Nach der Erkenntnis der Erfinder führen wegen der hohen Härte der Diamantschichten auch kleinere Unregelmäßigkeiten in der Schichtoberfläche im Zusammenhang mit der besonderen Faserstruktur des zu zerspanenden Werkstoffs zu schlechten Bohrungsflächen, Rattermarken beim Senken, oder sogar zum Werkzeugbruch.

Erfindungsgemäß wird ein Werkzeug als Schneidwerkzeug vorgeschlagen, das einen Werkzeugkörper mit geometrisch bestimmter Schneide aufweist mit mindestens einer Hauptfunktionsfläche. Hauptfunktionsflächen sind Flächen, die unmittelbar an die Schneidkanten oder -ecken angrenzen, insbesondere diejenigen Schneidkanten oder - ecken, die den höchsten Volumenanteil des Werkstücks zerspanen. Bei einem Bohrer sind dies bspw. die an die Schneidkanten der Hauptschneiden angrenzenden Flächen, wie die Hauptfreiflächen und zugehörigen Spanflächen, aber auch die Fase der Nebenschneidkanten oder Führungsfasen. Die höchste Zerspanungsleistung findet an der Schneidecke statt.

Erfindungsgemäß ist mindestens auf einer Hauptfunktionsfläche, bevorzugt auf dem gesamten Bearbeitungsbereich des Werkzeugs, d. h. des Teils, der das zu zerspanende Material in unmittelbarem Kontakt bearbeitet, eine Diamantbeschichtung aufgebracht. Bevorzugt handelt es sich hierbei um eine CVD-Diamantschicht, d. h. um eine unmittelbar auf einem Werkzeugsubstrat erzeugte und fest an diesem anhaftende Diamantschicht.

Die erfindungsgemäß vorgesehene Diamantschicht weist eine bestimmte topografische Eigenschaft der Oberfläche auf, die sich im Flächenrauheitswert Spk, der sogenannten "reduzierten Spitzenhöhe" widerspiegelt. Der Flächenrauheitswert Spk beträgt, gemessen an der Hauptfunktionsfläche oder wenigstens in einem Bereich der Hauptfunktionsfläche - erfindungsgemäß weniger als 0,25 µm.

Bei der nach EN ISO 25178 definierten reduzierten Spitzenhöhe Spk handelt es sich um einen Flächenwert, der besonders nach oben herausstehende Rauheitsspitzen einer sonst plateauartigen Oberfläche berücksichtigt, Vertiefungen wie tiefer gelegene Riefen, Rauheitstäler, etc. dagegen nicht. Überraschend hat sich gezeigt, dass Werkzeuge mit geometrisch bestimmter Schneide, bei denen auf der Hauptfunktionsfläche eine Diamantbeschichtung mit einer erfindungsgemäßen Oberflächentopologie aufgebracht ist, erhebliche Vorteile bei der Zerspanung von faserverstärkten Materialien aufweisen. Die erfindungsgemäße Oberflächenstruktur der Diamantbeschichtung weist, in Zahlen ausgedrückt durch den Parameter der reduzierten Spitzenhöhe Spk, nur in sehr geringem Maße nach außen herausstehende Auswüchse oder größere Einzelkristalle auf. In Einsatztests hat sich erwiesen, dass Werkzeuge mit einer solchermaßen beschichteten Schneide erhebliche Vorteile bieten, insbesondere deutlich erhöhte Standzeiten sowie sauberere Bohrungen.

Für die Bestimmung dieser Oberflächentopologie wird mindestens ein Messpunkt an mindestens einer Hauptfunktionsfläche betrachtet. Bevorzugte Messpunkte für die Ermittlung des o.g. Rauheitswerts sind die an die Schneidecke angrenzenden Flächenanteile, insbesondere der ersten Hauptfreifläche und/oder der Fase der Nebenschneide. Aus messtechnischen Gründen werden die Werte dabei bevorzugt am liegenden Bohrer auf dem unmittelbar an die Schneidkante angrenzenden Flächenanteil der Fase der Nebenschneide genommen. Da diese Flächenanteile eng benachbart sind, ergeben sich kaum Abweichungen in der Schichtmorphologie und Rauheit. Ein Vorteil der Bestimmung des Spk-Wertes ist dabei, dass dieser von der Messfläche weitgehend unabhängig ist und auch auf kleinen Flächenstücken genommen werden kann.

Nach von den Erfindern angestellten Überlegungen sind einzeln vorstehende Auswüchse oder größere Einzelkristalle einer sonst glatten Diamantschicht vermutlich deshalb verantwortlich für eine schlechte Zerspanoberfläche in faserverstärkten Materialien, insbesondere CFK-Werkstoffen, weil sie unter Umständen das Herausreißen von Fasern bewirken. Im Gegensatz zu herkömmlichen Werkzeugmaterialien, und sogar gegenüber bekannten anderen Hartstoffbeschichtungen auf Werkzeugschneiden, zeigt eine Diamantschicht durch ihre überaus hohe Härte ein anderes Einsatzverhalten, da sie sich nicht wie andere Materialien umgehend einglättet. Aus dem bearbeiteten faserverstärkten Material, bspw. an einer Bohrungswandung vorhandene Fasern können sich an den vorstehenden Spitzen einer Diamantschicht verfangen und so bspw. beim Bohren zum Aufschwingen führen. Insbesondere beim Senken kann dies zu sehr unsauberen, unrunden Senkungsflächen führen. Kommt es zu einem Herausreißen eines Auswuchses aus der Diamantschicht, kann dies sogar zum vollständigen Versagen der Schicht und damit des Werkzeugs führen.

Hingegen zeichnet sich das erfindungsgemäße Werkzeug, bei dem besonders wenig von der Oberfläche hervorstehende Spitzen und andere Auswüchse vorhanden sind, durch erheblich geringere Vibrationen beim Bohren aus, wie sie sich bei herkömmlichen Werkzeugen je nach Drehzahl in Form von Ratter- oder Quietschlauten bemerkbar machen. Dabei bleiben die grundsätzlichen Vorteile von diamantbeschichteten Werkzeugen erhalten, insbesondere der gute Widerstand gegen die Abrasion der Fasern und eine geringe Klebneigung oder Adhäsion in Bezug auf die Kunststoffmatrix oder die Metalllagen.

Diese Vorteile zeigen sich bereits bei der erfindungsgemäßen reduzierten Spitzenhöhe Spk von weniger als 0,25 µm. Noch deutlicher zeigen sich die Vorteile bei noch geringeren Spk-Werten von weniger als 0,2 µm, besonders bevorzugt von weniger als 0,15 µm.

Andere Rauheitsparameter wie die mittlere Rauheit Rₐ oder die Rautiefe R_{z} zeigen keinen eindeutigen Zusammenhang mit den Bearbeitungseigenschaften, bzw. haben deutlich geringeren Einfluss. Es kommt demnach nach Erkenntnis der Erfinder nicht vorrangig darauf an, eine vollständig glatte Diamantschicht vorzusehen, sondern vielmehr darauf, die vorstehend beschriebenen Spitzen und sonstigen vorstehenden Bereiche zu vermeiden, die sich im Spk-Wert widerspiegeln.

In Ausführungsformen der Erfindung kann hingegen die Flächenrauheit im Übrigen, ausgedrückt bspw. im Rauhigkeitsparameter der Rauhtiefe R_{z}, mit durchaus höheren Werten akzeptiert werden. Beispielsweise werden mit einer Diamantbeschichtung auf der Hauptfunktionsfläche, die zwar eine Rauhtiefe R_{z} von 0,4 µm oder mehr, gleichzeitig aber die erfindungsgemäße geringe reduzierte Spitzenhöhe aufweist, dennoch sehr gute Ergebnisse bei der Zerspanung von faserverstärkten Materialien erreicht. Sogar bei höheren Rauhtiefen R_{z} von 0,7 µm oder mehr, oder sogar 1,2 µm oder mehr wird der erfindungsgemäße Effekt erzielt, sofern nur der Spk-Wert erfindungsgemäß niedrig ist.

Die Vorteile der Erfindung können bei verschiedenen Werkzeugtypen mit bestimmter Schneide erzielt werden, insbesondere bei Fräsern, Wendeschneidplatten, etc.. Als besonders vorteilhaft hat sich die Erfindung bei Bohrwerkzeugen erwiesen. Die jeweils betrachtete Hauptfunktionsfläche ist dort eine unmittelbar an eine Haupt- oder Nebenschneidkante angrenzende Fläche. Besonders bevorzugt ist die Hauptfunktionsfläche unmittelbar an einer Schneidkante angeordnet, bspw. auf der Fase der Nebenschneide direkt unterhalb der Schneidecke.

Besondere Vorteile können bei Senk- bzw. Stufenbohrern erzielt werden. Senk- oder Stufenbohrer weisen einen ersten Bohrbereich mit geringerem Durchmesser und zweiten Bohrbereich mit größerem Durchmesser auf. Bei Senkbohrern wird mit dem ersten

Bohrbereich ein Werkstück durchbohrt und dann mit dem zweiten Bohrbereich eine Senkung hergestellt, bspw. für eine Niete. Dabei erweist sich der Übergang zwischen der Durchbohrung und der Senkung als besonders kritisch. Hier muss eine besonders saubere Bearbeitung des Werkstücks mit Herstellung eines Übergangs mit definiertem Radius oder einer Fase erfolgen. Andernfalls besteht das Risiko des sogenannten "head dishing", bei dem die Niete verformt wird und sich eindellt. Dabei kann es zu Mikrorissen im Nietenkopf und im schlimmsten Fall zum Versagen der Nietverbindung kommen.

Senkbohrer ohne Beschichtung verschleißen im Übergangsbereich zwischen dem ersten und zweiten Bohrbereich schnell, so dass der angestrebte saubere Übergang bald nicht mehr gewährleistet ist. Auch Senkbohrer mit herkömmlicher CVD-Diamantbeschichtung können im kritischen Übergangsbereich Unregelmäßigkeiten zeigen. Hingegen zeigt sich bei Senkbohrern, die eine Diamantbeschichtung mit der erfindungsgemäß geringen reduzierten Spitzenhöhe aufweisen, ein geringerer Verschleiß, so dass die gewünschte Bearbeitungsqualität im Übergang länger gewährleistet bleibt. Hier sind die erfindungsgemäßen Oberflächeneigenschaften von besonderer Bedeutung im Bereich des Übergangs zwischen den Stufen, also bspw. an den Span- und Freiflächen der Schneidkanten der zweiten Stufe sowie an der Führungsfase am Ende der ersten Stufe.

Gemäß einer bevorzugten Ausführungsform der Erfindung weist die Diamantbeschichtung mindestens eine Schicht aus nanokristallinem Diamant auf. Hierunter wird Diamant mit einer Kristallitgröße (Korngröße) im Nanometerbereich verstanden, also im Gegensatz zu mikrokristallinen Strukturen weniger als 1 µm. Bevorzugt weist die Schicht aus nanokristallinem Diamant Kristallitgrößen von 500 nm oder weniger auf, weiter bevorzugt 200 nm oder weniger, besonders bevorzugt 100 nm oder weniger. Besonders bevorzugt ist die äußere Oberfläche der Diamantbeschichtung durch eine Schicht aus nanokristallinem Diamant gebildet, so dass sich die Topologie der Oberfläche mit dem erfindungsgemäß niedrigen Spk-Wert gut einstellen lässt.

Bevorzugt ist die Diamantbeschichtung aus einer Abfolge von mindestens zwei verschiedenen Schichten gebildet. Bei beiden Schichten handelt es sich bevorzugt um Diamantschichten, allerdings mit unterschiedlicher Struktur. Beispielsweise kann eine Schicht aus mikrokristallinem Diamant und eine Schicht aus nanokristallinem Diamant vorgesehen sein. Ebenso ist eine Schichtfolge mit mehr als zwei Schichten (Multilayer) möglich, z. B. als mikrokristalline und nanokristalline Schichten im Wechsel.

Gemäß einer besonders bevorzugten Ausführungsform ist eine erste Schicht vorgesehen, die an die Oberfläche des Werkzeugkörpers anschließt und aus kristallinem Diamant besteht, und auf die eine zweite, weiter außen liegende Schicht aus Diamant aufgebracht ist, die eine geringere Korngröße als die erste Schicht aufweist. Insbesondere nanokristalliner Diamant in der zweiten, außen liegenden Schicht ist für die Bildung der glatten Oberfläche mit geringem Spk-Wert besonders bevorzugt. Die erste, substratnahe kristalline Diamantschicht von größerer Korngröße hat sich dabei als günstig für die Schichthaftung erwiesen.

Allerdings hat die erste, kristalline Schicht aufgrund der größeren Korngröße i.A. auch eine erhöhte Rauheit. Deshalb hat es sich als weiter vorteilhaft erwiesen, dass die Schichtdicke der zweiten Schicht größer ist als die Schichtdicke der ersten Schicht, insbesondere bevorzugt erheblich größer. So kann die Schichtdicke der zweiten Schicht bspw. mehr als das doppelte, bevorzugt das 10-fache oder mehr, besonders bevorzugt das 25-fache oder mehr der Schichtdicke der ersten Schicht betragen. Somit bildet die erste Diamantschicht, die bevorzugt in unmittelbarem Kontakt mit dem Werkzeugsubstrat steht, im wesentlichen eine relativ dünne Übergangsschicht, deren Rauheit aufgrund der geringen Schichtdicke begrenzt ist und die für eine gute Schichthaftung sorgt, während die zweite, bevorzugt nanokristalline Diamantschicht die glatte, von hervorstehenden Spitzen weitgehend freie äußere Oberfläche bilden kann, und wobei aufgrund der erheblich höheren Dicke der zweiten Schicht das Verschleißschutzvolumen maßgeblich durch diese Schicht bereitgestellt wird.

Beispielsweise kann die erste Schicht eine Schichtdicke im Bereich von 0,3 - 1,5 µm aufweisen. Weiter bevorzugt beträgt die Schichtdicke der ersten Schicht maximal 1,4 µm, besonders bevorzugt maximal 1µm. Hierdurch ließen sich gute Ergebnisse hinsichtlich der Schichthaftung erzielen, während die durch die erste Schicht eingebrachte Rauheit aufgrund der geringen Dicke noch akzeptabel war.

Die Gesamtschichtdicke der Diamantbeschichtung kann bspw. im Bereich von 3 - 30µm liegen. Allerdings ist einerseits ein gewisses Verschleißschutzvolumen vorteilhaft, andererseits kann bei höheren Schichtdicken die Rauheit zunehmen, so dass sich auch höhere Spk-Werte ergeben können. Für den speziellen Einsatzzweck der erfindungsgemäßen Werkzeuge hat sich daher eine relativ enge Auswahl als vorteilhaft erwiesen, und zwar beträgt gemäß einer Weiterbildung der Erfindung die Gesamtschichtdicke mindestens 6 µm. Weiter bevorzugt sind Gesamtschichtdicken von mindestens 7, besonders bevorzugt mindestens 8 µm. Als Obergrenze der Gesamtschichtdicke sind 12 µm, weiter bevorzugt 11 µm und besonders bevorzugt 10 µm vorgeschlagen, auch um durch die Begrenzung anwachsende Rauigkeiten der Oberfläche zu vermeiden. Somit hat sich nach den derzeit vorliegenden Erkenntnissen eine Schichtdicke im relativ engen Intervall von 7 - 12 µm als besonders günstig erwiesen, um ein für die Zerspanung von faserverstärkten Materialien besonders geeignetes Werkzeug bereitzustellen, das einerseits ausreichendes Verschleißschutzvolumen bietet, aber noch mit glatter Oberfläche gut herstellbar ist.

Dabei ist das erfindungsgemäße diamantbeschichtete Werkzeug besonders geeignet zum Bearbeiten auch von Sandwich-Materialien, bei denen mindestens eine Lage aus einem faserverstärkten Material, insbesondere einem Faserverbundwerkstoff besteht, und die weiter eine Metalllage, insbesondere Titan- oder Aluminium-Legierungen, aufweisen. Die Diamantschicht weist aufgrund ihrer hohen Härte sowohl ausreichende Widerstandsfähigkeit gegen die Abrasivität der Fasern auf als auch gute Bearbeitungseigenschaften für die Metalllage.

Im Fall der Bearbeitung von Sandwich-Materialien, bei denen mindestens eine Metalllage aus einer Titan- oder Aluminium-Legierung besteht, ist eine erhöhte Gesamtschichtdicke der Diamantbeschichtung bevorzugt. Bspw. hat sich für Sandwich-Materialien mit einer Metallage aus einer Aluminium-Legierung gezeigt, dass gegenüber der reinen CFK-Bearbeitung eine um ca. 2µm erhöhte Schichtdicke vorteilhaft ist, im Fall einer Titan-Legierung sogar um ca. 4 µm. Beide Materialien können zu Aufschmierungen an der Werkzeugoberfläche führen. Besonders eine Titanlegierung erhöht zudem die Schnittkräfte und Temperaturen bei der Zerspanung. Für besonders lange Standzeiten und/oder besonders verschließträchtige Werkstoffe kann die Schichtstärke noch weiter erhöht werden, bspw. um 8µm. Werden dabei beim Aufbringen der Diamantschicht die Spk-Werte zu hoch, kann die Schicht ggfs. nachbearbeitet werden.

Die erfindungsgemäße Oberflächentopologie wird durch eine hierauf gezielte Anwendung des Herstellungsverfahrens, insbesondere Hot-Filament CVD, erzielt. Alle Prozessschritte, ausgehend von der Substratvorbehandlung bis zum Aufbringen der Beschichtung sollten dabei so umsichtig und kontrolliert ausgeführt werden, dass die angestrebten Spk-Werte letztlich nicht überschritten werden. So kann bspw. bei der Substratvorbehandlung in einem Ätzverfahren die Ätztiefe begrenzt werden. Durch Verzicht auf einen Strahlprozess können glattere Schichten erzeugt werden. Beim Aufbringen der Beschichtung kann die Herstellung einer Oberfläche mit geringem Spk-Wert auf Kosten der Schichtrate bspw. durch eine niedrigere Prozesstemperatur im Beschichtungsprozess erreicht werden. Im Hot-Filament Prozess kann dies durch eine Reduzierung der Filamentleistung, oder bevorzugt durch eine veränderte Positionierung der zu beschichtenden Werkzeugsubstrate gegenüber den Filamenten erreicht werden. Da die Überprüfung der letztlich erzielten Oberflächentopologie einfach möglich ist, kann nach derartigen Maßgaben für die verschiedensten Werkzeuge jeweils ein geeigneter Prozess ausgeführt werden.

Im Fall eines für die Zerspanung von Sandwich-Materialien mit Metallagen aus Titan- oder Aluminiumlegierungen geeigneten Werkzeugs wird dabei bei der chemischen Vorbehandlung eine etwas höhere Rauheit eingestellt. Im Fall von Titan hat es sich als vorteilhaft erwiesen, wenn das Substrat vor der chemischen Vorbehandlung zusätzlich noch schonend gesandstrahlt wird. Beide Maßnahmen erhöhen u. U. die Schichtrauheit oder den Spk-Wert in einem gewissen Maß, so dass bei dann folgenden Prozessschritten besonders darauf geachtet werden muss, dass der angestrebte Spk-Wert des fertigen Werkzeugs nicht überschritten wird.

Nachfolgend wird eine Ausführungsform der Erfindung anhand von Zeichnungen näher beschrieben. In den Zeichnungen zeigen:
- Fig. 1: in Seitenansicht einen Bohrer;
- Fig. 2: in vergrößerter Darstellung einen Querschnitt durch eine Schneide und eine Hauptfunktionsfläche des Bohrers aus Fig. 1;
- Fig. 3: in schematischer Darstellung den Aufbau einer Beschichtung der Hauptfunktionsfläche aus Fig. 2;
- Fig. 4a, 4b: beispielhafte Rauigkeitsprofile zur Erläuterung von Rauigkeitsparametern;
- Fig. 5a, 5b: Aufnahmen von Bohrlöchern, die mit einem Werkzeug gemäß einer Ausführungsform der Erfindung sowie mit einem Vergleichswerkzeug erstellt wurden;
- Fig. 6: in teilweise geschnittener Seitenansicht einen Stufenbohrer in einem Werkstück.

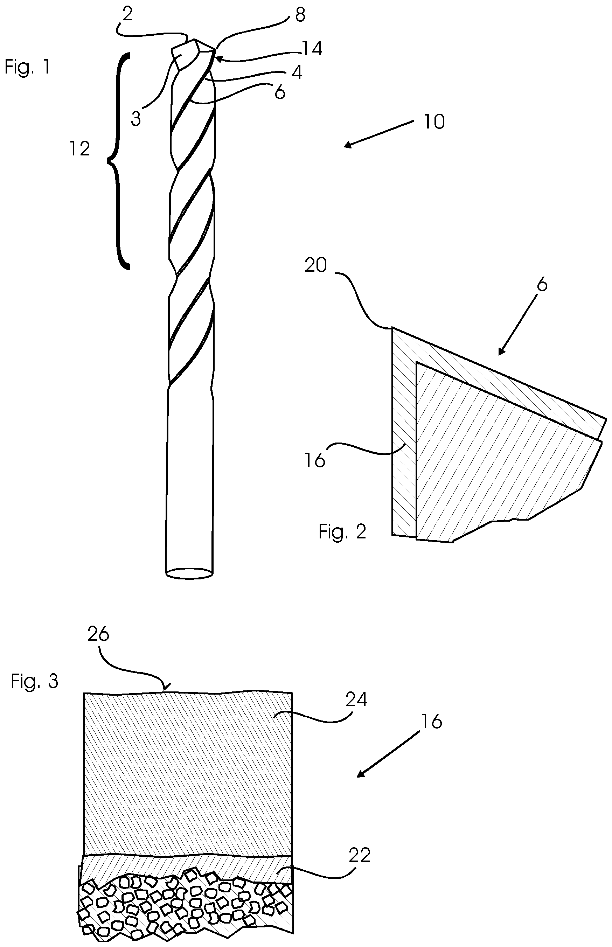

Fig. 1 zeigt in einer Seitenansicht einen Bohrer 10 als ein Beispiel eines Werkzeugs gemäß einer Ausführungsform der Erfindung. Der Bohrer 10 weist einen Bearbeitungsbereich 12 auf mit verschiedenen Schneidkanten 20, an der Spitze angeordneten Hauptschneiden 2 und einem daran anschließenden Wendelbereich mit Nebenschneiden 4. Die äußeren Enden der Hauptschneiden 2 bilden Schneidecken 8.

Spanflächen 3 grenzen an den Hauptschneiden 2 an. An den Nebenschneiden 4 sind Fasen 6 gebildet.

Der Bohrer 10 besteht aus einem Hartmetall-Material, insbesondere einem WC/Co-Hartmetall und ist an seinem Bearbeitungsbereich 12 mit einer Diamantbeschichtung 16 beschichtet.

Flächen, die an die Schneidkanten 20 angrenzen, werden als Hauptfunktionsflächen des Bohrers 10 bezeichnet. So stellen die Fasen 6 der Nebenschneiden 4 Hauptfunktionsflächen des Bohrers 10 dar, die unmittelbar an die Schneidkante 20 angrenzen. Die Spanflächen 3 an den Hauptschneiden 2 stellen ebenfalls Hauptfunktionsflächen des Bohrers 10 dar.

Fig. 2 zeigt schematisch einen Schnitt durch eine Schneidkante 20 mit einer Diamantbeschichtung 16. Bei der Schneidkante 20 kann es sich bspw. um eine Haupt- oder Nebenschneide 2, 4 handeln. Beispielsweise im Fall der Nebenschneide 4 bildet die Fase 6 der Nebenschneide, unmittelbar angrenzend an die Schneidkante 20, eine Hauptfunktionsfläche des Bohrers 10.

Fig. 3 zeigt schematisch den Aufbau der Diamantbeschichtung 16 an der in Fig. 2 betrachteten Hauptfunktionsfläche 6. Diese ist im gezeigten Beispiel zweilagig. Auf dem WC/Co-Hartmetallsubstrat ist zunächst eine erste Diamantschicht 22 aus mikrokristallinem Diamant aufgebracht. Direkt auf der ersten Diamantschicht 22 ist eine zweite Diamantschicht 24 aus nanokristallinem Diamant aufgebracht. Die zweite Diamantschicht 24 ist dabei erheblich dicker als die erste Diamantschicht 22.

Die äußere Oberfläche 26 der Diamantbeschichtung 16 wird durch die nanokristalline zweite Diamantschicht 24 gebildet. Die Oberfläche 26 hat eine sehr glatte Struktur, wobei sich insbesondere an der Oberfläche 26 keine nach oben vorstehenden Spitzen, Auswüchse oder größere Einzelkristalle befinden.

Die Topologie der Oberfläche 26 kann durch genormte Rauheitsparameter charakterisiert werden, hier insbesondere den Flächenrauheitswert der "reduzierten Spitzenhöhe", kurz Spk. Die Flächenrauheitswert der reduzierten Spitzenhöhe Spk ist genormt nach EN ISO 25178. Bei der "reduzierten Spitzenhöhe" handelt es sich um einen Flächenwert, der besonders nach oben herausstehende Rauheitsspitzen einer sonst plateauartigen Oberfläche berücksichtigt, tiefer gelegene Riefen bzw. Rauheitstäler dagegen nicht.

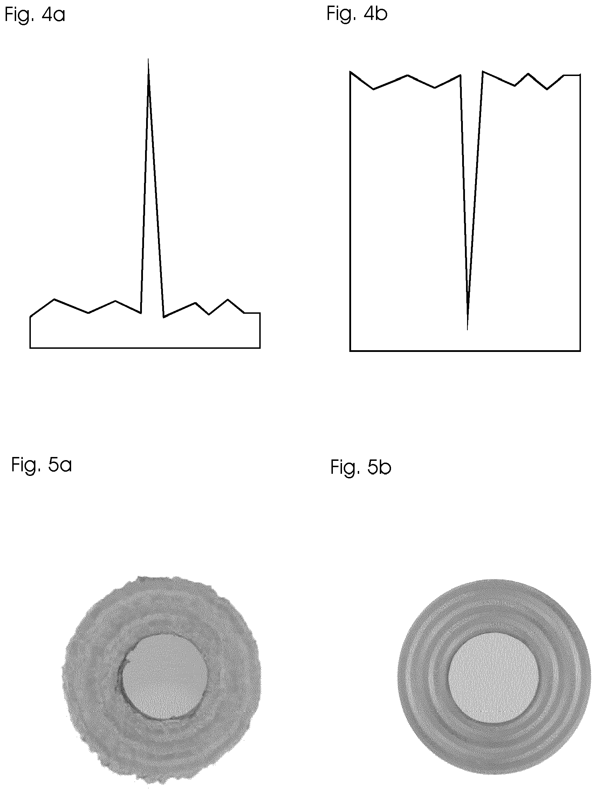

Der Parameter der reduzierten Spitzenhöhe unterscheidet sich dabei in der Beurteilung erheblich von Rauheitskennwerten, die lediglich allgemein die Rauheit bzw. Glätte einer Oberfläche beschreiben, ohne besondere Bewertung von herausstehenden Spitzen. Beispielhaft zeigen die Darstellungen in Fig. 4a, 4b symbolisch zwei zueinander inverse Rauheitsprofile, in Fig. 4a mit einer zentral hervorstehenden Spitze und in Fig. 4b mit einem hierzu inversen mittleren Tal. Der Wert der Rautiefe Rz ist für beide Profile aus Fig. 4a, 4b identisch. Hingegen stellt sich die Topologie des Profils aus Fig. 4b für die Bearbeitung von faserverstärkten Materialien als erheblich günstiger dar, da eine hervorstehende Spitze wie in Fig. 4a gezeigt eher zu einem Herausreißen von Fasern bei der Bearbeitung von faserverstärkten Materialien, bspw. CFK-Werkstoffen führen kann.

Der Parameter der reduzierten Spitzenhöhe gem. EN ISO 25178 berücksichtigt dies. Der Wert lässt sich gut mit heutigen optischen 3D-Rauheitsmessgeräten bestimmen. Gemäß ISO 13565-2 ist der Wert der zweidimensionalen reduzierten Spitzenhöhe Rpk definiert. Bei einer bevorzugten Berechnungsmethode für den Spk-Wert wird dieser identisch berechnet, allerdings auf Basis der flächenhaften Materialkurve anstelle der Materialkurve, die aus einem einzelnen Profilschnitt entwickelt wird. Hierfür wird die Norm ISO 25178 verwendet.

Bei der Beurteilung von Ausführungsbeispielen der Erfindung wurden die Oberflächen mit einem optischen 3D-Messgerät "µsurf explorer" der Firma Nano Focus AG ermittelt. Der Spk-Wert wurde über die zugehörige Software "µsoft analysis" wie oben beschrieben berechnet. Die Form des Werkzeugs wurde zur Messung mit einem Polynom zweiter Ordnung berücksichtigt. Bevorzugt erfolgt dabei die Analyse an der Fase 6 der Nebenschneide 4, direkt unterhalb der Schneidecke 8. Diese Stelle ist in Fig. 1 mit dem Bezugszeichen 14 bezeichnet.

Aufgrund der glatten, von vorstehenden Spitzen und Auswüchsen weitgehend freien Oberfläche 26 auf der Hauptfunktionsfläche 6 ist der Bohrer 10 sehr gut geeignet zur Bearbeitung insbesondere von kohlefaserverstärkten Matrixmaterialien wie CFK und CFC.

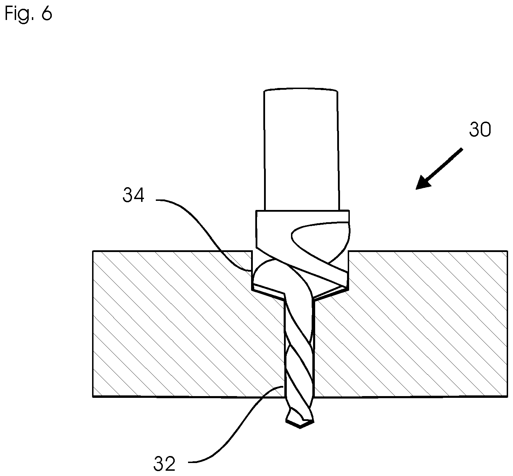

Fig. 6 zeigt einen Stufenbohrer (Senkbohrer, Bohrsenker) 30 mit einem ersten Bohrbereich 32 von geringerem Durchmesser und einem zweiten Bohrbereich 34 von größerem Durchmesser. Wie in Fig. 6 schematisch gezeigt, kann der Senkbohrer 30 zur Herstellung von Senkungen in einem Werkstück verwendet werden.

Fig. 5b zeigt beispielhaft mit einem Bohrsenker hergestellte Nietenbohrungen, wobei die Hauptfunktionsfläche die oben beschriebene Oberflächentopologie mit einem Spk-Wert von 0,12 µm aufweist. Zum Vergleich ist in Fig. 5a eine unter selben Bedingungen hergestellte Nietenbohrung mit einem konventionellen CVD-diamantbeschichteten Werkzeug dargestellt. Der Spk-Wert des konventionellen Vergleichswerkzeugs, gemessen auf der Oberfläche der Beschichtung an der Hauptfunktionsfläche, beträgt 0,3 µm.

Bereits beim Bohren zeigt sich, dass das Werkzeug mit der glatten Oberfläche mit geringem Spk-Wert ruhig läuft, während das konventionelle Vergleichswerkzeug erhebliche Vibrationen erfährt. In der Beurteilung der Bohrungen zeigt sich im Fall der glatten Beschichtungsoberfläche eine saubere Bohrung, während das konventionelle Werkzeug in dem CFK-Sandwich-Material aufgrund einer Zusammenwirkung der darin enthaltenen Kohlefasern mit hervorstehenden Spitzen auf der Beschichtung unsaubere, unrunde Senkungsflächen zeigt.

Das Aufbringen der Beschichtung 16, im gezeigten Beispiel bestehend aus den Diamantschichten 22, 24, erfolgt nach Vorbehandlung des Hartmetall-Substrats in einem Ausführungsbeispiel als CVD-Diamantbeschichtung im Hot-Filament-Verfahren.

Dabei wird das Hartmetallsubstrat zunächst bei der Vorbehandlung chemisch und/oder elektrochemisch geätzt. Die Vorbehandlung dient dem Entfernen des für das Diamantwachstum und die Schichthaftung schädlichen Kobalts. Sie kann zusätzlich auch zum Abtragen der Schleifhaut dienen und/oder zur Aufrauung der Oberfläche für eine verbesserte Haftung durch eine mechanische Verklammerung zwischen Schicht und Substrat. Geeignete Vorbehandlungsverfahren sind insbesondere in WO 2004/031437 A1 und in WO 2007/140 931 A1 der Anmelderin beschrieben. Zur Konditionierung der Oberflächen kann zuvor eine Behandlung durch Sandstrahlen erfolgen.

Bei der anschließenden CVD-Diamantbeschichtung mithilfe des Hot-Filament-Verfahrens werden die Werkzeuge bevorzugt zwischen zwei parallele Reihen aus senkrechten Filamenten positioniert, wie in der WO 98/35071 der Anmelderin beschrieben. Durch Vorgabe verschiedener Parameter der Beschichtungsanlage während des Beschichtungsvorgangs können die beiden Diamantschichten 22, 24 erzeugt werden, wie beispielsweise in WO 00/60137 A1 der Anmelderin beschrieben. Eine nanokristalline Struktur der äußeren Schicht 24 kann dabei durch einen Beschichtungsprozess erzeugt werden, der gemäß WO 2004/083 484 A1 der Anmelderin mit seinen Prozessparametern zwischen Zuständen verschiedenstarker Kohlenstoffübersättigung pendelt.

Die besondere Topologie der Oberfläche wird dabei möglich durch die bei dem angegebenen Verfahren der WO 2004/083 484 A1 entstehenden besonders glatten Diamantschichten, die sogar eine Nivellierung der darunter liegenden, etwas raueren mikrokristallinen Diamantschicht 22 bewirken. Zuvor wird die oben beschriebene chemische Ätzung nur schonend mit geringer Ätztiefe vorgenommen, um ein relativ glattes Substrat zu erhalten. Weiter begünstigt wird die glatte Oberfläche 26 durch den Aufbau der Diamantbeschichtung 16 aus einer ersten Diamantschicht 22 relativ geringer Dicke und einer darüber liegenden, erheblich dickeren nanokristallinen Diamantschicht 24. Die Gesamtschichtdicke ist dabei begrenzt auf bspw. maximal 12 µm, besonders bevorzugt minimal 8 und maximal 10 µm. Bei einer entsprechend geringen Schichtdicke kann bereits bei der Herstellung im CVD-Verfahren eine glatte Oberfläche 26 mit dem gefordert niedrigen Spk-Wert erreicht werden.

Ergänzend oder alternativ kann die Oberfläche 26 nachbearbeitet werden, um den gewünschten Rauheitsparameter bereitzustellen. Die Nachbearbeitung kann mit Diamantwerkzeugen bzw. Diamantschleifscheiben, oder durch eine Plasma- bzw. Laserglättung erfolgen.

### Beispiele

Ein 8mm-Bohrer aus EMT100-Hartmetall mit 6 Gew.% Co wird zunächst elektrochemisch geätzt und dabei gleichmäßig um 6 µm abgetragen. Dann wird eine besonders schonende chemische Vorbehandlung durchgeführt wie in WO 2004/031437 A1 beschrieben, die den Kobalt oberflächennah reduziert und eine leichte Aufrauung bewirkt. Diese Vorbehandlung vermindert den Durchmesser des Bohrers um weitere 2 µm. Anschließend wird eine 0,3 µm dicke kristalline Schicht mittels des Hot-Filament-Verfahrens in einer Beschichtungsanlage vom Typ CC800/9Dia aufgebracht. Anschließend werden ohne Vakuumunterbrechung im gleichen Prozess die Beschichtungsparameter geändert, so dass mit einem zwischen verschiedenen Betriebszuständen pendelnden Verfahren gem. WO 2004/083 484 A1 eine nanokristalline Schicht bis auf die Gesamtschichtdicke von 8 µm aufgetragen wird.

Das so hergestellte Werkzeug zeigt beim Bohren von Nietlöchern in einem CFK-Material eine gegenüber herkömmlichen, mit CVD-diamantbeschichteten Werkzeugen erhöhte Lochanzahl, wobei die Bohrungsqualität wie im Vergleich der Darstellungen Fig. 5a, 5b ersichtlich gegenüber herkömmlichen Bearbeitungen, bei denen ausgefranste Faserstummel in der Bohrung sichtbar sind, erheblich erhöht ist.

In einem weiteren Beispiel wird ein 8mm-Bohrer ausgehend von demselben Werkzeugsubstrat wie im ersten Beispiel hergestellt. Um damit Sandwich-Materialien mit mindestens einer Metallage aus einer Aluminium-Legierung zerspanen zu können, wird - bei sonst gleicher Herstellung wie oben beschrieben - eine etwas stärkere Ätzung vorgenommen. So ergibt sich eine bessere Schichthaftung, auch wenn hierdurch die Rauheit etwa erhöht wird. Der Abtrag bei der chemischen Vorbehandlung beträgt dann 3µm. Die Gesamtschichtdicke der Diamantbeschichtung beträgt mit 10µm etwas mehr als im Fall des obigen, vor allem für reine CFK-Bearbeitung vorgesehenen Werkzeugs.

In einem weiteren Beispiel eines Bohrers zur Bearbeitung von Sandwich-Materialien mit einer Metallage aus einer Titan-Legierung erfolgt die Herstellung wie oben für das Sandwich-Aluminium-Werkzeug beschrieben, wobei allerdings das Substrat vorher zusätzlich durch Sandstrahlen behandelt wird. Die Gesamtschichtdicke beträgt dann mit 12µm noch etwas mehr, so dass bessere Eigenschaften für die Zerspanung des Titan-Materials erzielt werden.

## Patentansprüche

1. Werkzeug zum Zerspanen von faserverstärkten Materialien mit,
- einem Werkzeugkörper (10) mit bestimmter Schneide (20) mit mindestens einer Hauptfunktionsfläche (6),
- und einer mindestens auf der Hauptfunktionsfläche (6) aufgebrachten Diamantbeschichtung (16), **dadurch gekennzeichnet, dass** die Oberfläche (26) der Diamantbeschichtung (16) eine reduzierte Spitzenhöhe Spk von weniger als 0,25 µm aufweist.

2. Werkzeug nach Anspruch 1, bei dem
- die Oberfläche (26) der Diamantbeschichtung (16) eine reduzierte Spitzenhöhe Spk von weniger als 0,2 µm aufweist, bevorzugt sind weniger als 0,15 µm.

3. Werkzeug nach einem der vorangehenden Ansprüche, bei dem
- die Oberfläche (26) der Diamantbeschichtung (16) eine Rautiefe Rz von 0,4 µm oder mehr, bevorzugt 0,7 µm oder mehr, besonders bevorzugt 1,2 µm oder mehr aufweist.

4. Werkzeug nach einem der vorangehenden Ansprüche, bei dem
- die Diamantbeschichtung (16) mindestens eine Schicht (24) aus nanokristallinem Diamant aufweist.

5. Werkzeug nach einem der vorangehenden Ansprüche, bei dem
- die Diamantbeschichtung (16) aus mindestens zwei verschiedenen Schichten (22, 24) gebildet ist.

6. Werkzeug nach Anspruch 5, bei dem
- die Diamantbeschichtung (16) eine erste Schicht (22) umfasst, die an die Oberfläche des Werkzeugkörpers (10) anschließt und aus kristallinem Diamant besteht,
- und eine zweite, weiter außen liegende Schicht (24) aus Diamant mit einer Korngröße, die geringer ist als die Korngröße der ersten Schicht (22), wobei bevorzugt die zweite Schicht (24) aus nanokristallinem Diamant besteht.

7. Werkzeug nach Anspruch 6, bei dem
- die Schichtdicke der zweiten Schicht (24) größer ist als die Schichtdicke der ersten Schicht (22), insbesondere bevorzugt die Schichtdicke der zweiten Schicht (24) das 25-fache oder mehr der Schichtdicke der ersten Schicht (22) beträgt.

8. Werkzeug nach einem der vorangehenden Ansprüche, bei dem
- die Diamantbeschichtung (16) eine Gesamtschichtdicke aufweist, die mindestens 6 µm, bevorzugt mindestens 7 µm, besonders bevorzugt mindestens 8 µm beträgt.

9. Werkzeug nach einem der vorangehenden Ansprüche, bei dem
- die Diamantbeschichtung (16) eine Gesamtschichtdicke aufweist, die maximal 12 µm, bevorzugt maximal 11 µm, besonders bevorzugt maximal 10 µm beträgt.

10. Werkzeug nach einem der vorangehenden Ansprüche, bei dem
- der Werkzeugkörper (10) mindestens an der Schneide (20) aus einem Hartmetall besteht.

11. Werkzeug nach einem der vorangehenden Ansprüche, bei dem das Werkzeug ein Bohrwerkzeug ist, und die Hauptfunktionsfläche (6) eine an eine Haupt- oder Nebenschneide (2, 4) angrenzende Fläche ist.

12. Verwendung eines Werkzeugs nach einem der vorangehenden Ansprüche zum Zerspanen von faserverstärkten Materialien.

13. Verfahren zum Zerspanen von faserverstärkten Materialien, bei dem ein Werkzeug (10) nach einem der Ansprüche 1 - 11 zur Zerspanung verwendet wird.

14. Verfahren nach Anspruch 13, bei dem
- mit dem Werkzeug (10) ein Sandwich-Material zerspant wird,
- wobei das Sandwich-Material mindestens eine Lage aus einem Faserverbundwerkstoff und mindestens eine Lage aus einer Metalllegierung aufweist.

15. Verfahren nach Anspruch 14, bei dem
- die Metalllegierung eine Titan- oder Aluminiumlegierung ist.

## Claims

1. A tool for machining fiber-reinforced materials with,
- a tool body (10) with a certain cutting edge (20) with at least one main function surface (6),
- and a diamond coating (16) applied at least to the main function surface (6),
**characterized in that**
the surface (26) of the diamond coating (16) has a reduced peak height Spk of less than 0.25 µm.

2. The tool according to claim 1, wherein
- the surface (26) of the diamond coating (16) has a reduced peak height Spk of less than 0.2 µm, preferably less than 0.15 µm.

3. The tool according to one of the preceding claims, wherein
- the surface (26) of the diamond coating (16) has a roughness depth Rz of 0.4 µm or more, preferably 0.7 µm or more, particularly preferably 1.2 µm or more.

4. The tool according to one of the preceding claims, wherein
- the diamond coating (16) has at least one layer (24) made of nanocrystalline diamond.

5. The tool according to one of the preceding claims, wherein
- the diamond coating (16) is formed from at least two different layers (22, 24).

6. The tool according to claim 5, wherein
- the diamond coating (16) comprises a first layer (22) which connects to the surface of the tool body (10) and is made of crystalline diamond,
- and a second layer (24) lying further outside made of diamond with a grain size which is smaller than the grain size of the first layer (22), wherein the second layer (24) is preferably made of nanocrystalline diamond.

7. The tool according to claim 6, wherein
- the layer thickness of the second layer (24) is greater than the layer thickness of the first layer (22); particularly preferably the layer thickness of the second layer (24) is 25 times or more than the layer thickness of the first layer (22).

8. The tool according to one of the preceding claims, wherein
- the diamond coating (16) has a total layer thickness which is at least 6 µm, preferably at least 7 µm, particularly preferably at least 8 µm.

9. The tool according to one of the preceding claims, wherein
- the diamond coating (16) has a total layer thickness which is a maximum of 12 µm, preferably a maximum of 11 µm, particularly preferably a maximum of 10 µm

10. The tool according to one of the preceding claims, wherein
- the tool body (10) is made of a hard metal at least on the cutting edge (20).

11. The tool according to one of the preceding claims, wherein the tool is a drilling tool, and the main function surface (6) is a surface adjacent to a main or secondary cutting edge (2, 4).

12. A use of a tool according to one of the preceding claims for machining fiber-reinforced materials.

13. A method for machining fiber-reinforced materials, wherein a tool (10) according to one of claims 1 - 11 is used for machining.

14. The method according to claim 13, wherein
- a sandwich material is machined with the tool (10),
- wherein the sandwich material has at least one layer made of a fiber composite material and at least one layer made of a metal alloy.

15. The method according to claim 14, wherein
- the metal alloy is a titanium or aluminum alloy.

## Revendications

1. Outil d'usinage de matériaux renforcés par des fibres comprenant
- un corps d'outil (10) doté d'une arête de coupe (20) donnée avec au moins une surface de travail principale (6),
- et un revêtement diamanté (16) appliqué au moins sur la surface de travail principale (6),
**caractérisé en ce que**
la surface (26) du revêtement diamanté (16) présente une hauteur de crête réduite Spk inférieure à 0,25 µm.

2. Outil selon la revendication 1, dans lequel
- la surface (26) du revêtement diamanté (16) présente une hauteur de crête réduite Spk inférieure à 0,2 µm, de préférence inférieure à 0,15 µm.

3. Outil selon l'une des revendications précédentes, dans lequel
- la surface (26) du revêtement diamanté (16) présente une rugosité Rz de 0,4 µm ou plus, de préférence 0,7 µm ou plus, de manière particulièrement préférentielle 1,2 µm ou plus.

4. Outil selon l'une des revendications précédentes, dans lequel
- le revêtement diamanté (16) présente au moins une couche (24) de diamant nanocristallin.

5. Outil selon l'une des revendications précédentes, dans lequel
- le revêtement diamanté (16) est formé d'au moins deux couches différentes (22, 24).

6. Outil selon la revendication 5, dans lequel
- le revêtement diamanté (16) comprend une première couche (22), qui est adjacente à la surface du corps d'outil (10) et se compose de diamant cristallin,
- et une seconde couche (24) située plus à l'extérieur en diamant avec une grosseur de grain qui est inférieure à la grosseur de grain de la première couche (22), la seconde couche (24) se composant de préférence de diamant nanocristallin.

7. Outil selon la revendication 6, dans lequel
- l'épaisseur de couche de la seconde couche (24) est supérieure à l'épaisseur de couche de la première couche (22), de manière particulièrement préférentielle l'épaisseur de couche de la seconde couche (24) correspond à 25 fois ou plus l'épaisseur de couche de la première couche (22).

8. Outil selon l'une des revendications précédentes, dans lequel
- le revêtement diamanté (16) présente une épaisseur de couche totale qui est d'au moins 6 µm, de préférence au moins 7 µm, de manière particulièrement préférentielle au moins 8 µm.

9. Outil selon l'une des revendications précédentes, dans lequel
- le revêtement diamanté (16) présente une épaisseur de couche totale qui est de 12 µm maximum, de préférence 11 µm maximum, de manière particulièrement préférentielle 10 µm maximum.

10. Outil selon l'une des revendications précédentes, dans lequel
- le corps d'outil (10) se compose d'un métal dur au moins sur l'arête de coupe (20).

11. Outil selon l'une des revendications précédentes, dans lequel l'outil est un outil d'alésage, et la surface de travail principale (6) est une surface adjacente à une arête de coupe principale ou secondaire (2, 4).

12. Utilisation d'un outil selon l'une des revendications précédentes pour l'usinage de matériaux renforcés par des fibres.

13. Procédé d'usinage de matériaux renforcés par des fibres, dans lequel un outil (10) selon l'une des revendications 1 à 11 est utilisé pour l'usinage.

14. Procédé selon la revendication 13, dans lequel
- un matériau sandwich est usiné avec l'outil (10),
- le matériau sandwich présentant au moins une couche en matériau composite renforcé par des fibres et au moins une couche en alliage métallique.

15. Procédé selon la revendication 14, dans lequel
- l'alliage métallique est un alliage de titane ou d'aluminium.
